(19) Europäisches Patentamt
European Patent Office
Office européen des brevets

(11) **EP 4 310 521 B1**

(12) **EUROPÄISCHE PATENTSCHRIFT**

(45) Veröffentlichungstag und Bekanntmachung des Hinweises auf die Patenterteilung:
**16.04.2025 Patentblatt 2025/16**

(21) Anmeldenummer: **22185717.0**

(22) Anmeldetag: **19.07.2022**

(51) Internationale Patentklassifikation (IPC):
***G01R 31/08*** (2020.01)

(52) Gemeinsame Patentklassifikation (CPC):
**G01R 31/085;** G01R 31/088

(54) **VERFAHREN UND SCHUTZGERÄT ZUM ORTEN EINES FEHLERS**

METHOD AND SAFETY DEVICE FOR LOCATING A FAULT

PROCÉDÉ ET APPAREIL DE PROTECTION PERMETTANT DE LOCALISER UNE DÉFAILLANCE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**24.01.2024 Patentblatt 2024/04**

(73) Patentinhaber: **Siemens Aktiengesellschaft 80333 München (DE)**

(72) Erfinder:
• **Gawlik, Wolfgang**
  Wien (AT)
• **Cox, Benjamin**
  Wien (AT)
• **Kustura, Tarik**
  Wien (AT)

(74) Vertreter: **Siemens Patent Attorneys Postfach 22 16 34 80506 München (DE)**

(56) Entgegenhaltungen:
**EP-A1- 3 964 847**

• **WASHER MARIE ET AL: "Precise impedance based fault location algorithm with fault resistance separation", 2015 IEEE EINDHOVEN POWERTECH, IEEE, 29 June 2015 (2015-06-29), pages 1 - 6, XP033215617, DOI: 10.1109/ PTC.2015.7232595**

EP 4 310 521 B1

**Beschreibung**

Die Erfindung bezieht sich auf ein Verfahren zum Orten eines Fehlers in einem Leitungsabschnitt einer dreiphasigen elektrischen Energieübertragungsleitung, wobei bei dem Verfahren zumindest ein Iterationsschritt ausgeführt wird, der umfasst ein Ortsberechnungsverfahren, bei dem eine Fehlerortsangabe unter Berücksichtigung einer Hilfsangabe ermittelt wird, und ein Modifikationsverfahren, bei dem eine modifizierte Hilfsangabe gebildet wird, mit dem sich das Ortsberechnungsverfahren wiederholen lässt, um eine neue Fehlerortsangabe zu bilden, wobei der Iterationsschritt im Rahmen einer Iteration wiederholt wird, bis ein vorgegebenes Abbruchkriterium erfüllt wird.

Ein solches Verfahren ist beispielsweise in der Veröffentlichungsschrift "Precise Impedance Based Fault Location Algorithm with Fault Resistance Separation" (Marie Washer and Jean-Claude Maun, École polytechnique de Bruxelles, Université Libre de Bruxelles, Brussels, Belgium; Cezary Dzienis, Matthias Kereit, Yilmaz Yelgin and Joerg Blumschein, EM EA PRO D, Siemens AG Berlin, Germany) offenbart.

Der Erfindung liegt die Aufgabe zugrunde, ein Verfahren der oben beschriebenen Art mit Blick auf ein verbessertes Konvergenzverhalten der Iteration noch weiter zu verbessern.

Diese Aufgabe wird erfindungsgemäß durch ein Verfahren mit den Merkmalen gemäß Patentanspruch 1 gelöst. Vorteilhafte Ausgestaltungen des erfindungsgemäßen Verfahrens sind in Unteransprüchen angegeben.

Danach ist erfindungsgemäß vorgesehen, dass die Hilfsangabe eine Kompensationsangabe ist, die einen Schätzort beschreibt, an dem sich der Fehler befinden könnte, und zumindest zwei unterschiedliche Modifikationsverfahren zur Verfügung stehen und in jedem Iterationsschritt geprüft wird, welches der Modifikationsverfahren im jeweiligen Iterationsschritt verwendet werden soll, wobei die Wahl des Modifikationsverfahrens von einer Empfindlichkeitsangabe abhängt, die den Einfluss der Kompensationsangabe auf die Fehlerortsangabe quantitativ beschreibt.

Ein wesentlicher Vorteil des erfindungsgemäßen Verfahrens besteht darin, dass die bereits aus der oben genannten Druckschrift vorbekannte Iteration durch das Vorsehen zumindest zweier unterschiedlicher Modifikationsverfahren in den meisten Fällen eine zügige Konvergenz erzielt werden kann, weil eine ungebremste Iteration in die falsche Iterationsrichtung mit einer sich erhöhenden Abweichung zwischen der im Iterationsschritt herangezogenen Kompensationsangabe von der optimalen Kompensationsangabe und damit eine sich erhöhende Abweichung zwischen der zu ermittelnden korrekten Fehlerortsangabe von der im Iterationsschritt ermittelten Fehlerortsangabe immer, zumindest in den meisten Fällen, vermeidbar ist.

Vorteilhaft ist es, wenn die Empfindlichkeitsangabe berechnet wird durch Ableitung der Fehlerortsangabe nach der Kompensationsangabe gemäß

$$E = dMm/dMc$$

wobei E die Empfindlichkeitsangabe, Mm die Fehlerortsangabe und Mc die Kompensationsangabe bezeichnet.

Die Kompensationsangabe beschreibt vorzugsweise einen Schätzort, an dem sich der Fehler befinden könnte. Die Kompensationsangabe könnte demgemäß auch als Schätzortangabe bezeichnet werden.

Die Fehlerortsangabe und die Kompensationsangabe sind vorzugsweise relative Angaben und definieren vorzugsweise, welchen Abstand der Fehler von der Messstelle bezogen auf die Länge des Leitungsabschnitts aufweist.

Die Empfindlichkeitsangabe wird vorzugsweise durch numerische Differentiation ermittelt.

Als besonders vorteilhaft wird es angesehen, wenn bei jedem der zwei Modifikationsverfahren die modifizierte Kompensationsangabe jeweils in Abhängigkeit von der zuletzt ermittelten Fehlerortsangabe ermittelt wird.

Bei einer besonders bevorzugten Ausgestaltung des Verfahrens ist vorgesehen, dass eines der zumindest zwei Modifikationsverfahren ein Modifikationsverfahren erster Art ist, bei dem die im vorherigen Ortsberechnungsverfahren ermittelte letzte Fehlerortsangabe als modifizierte Kompensationsangabe für den nächsten Iterationsschritt festgelegt wird.

Bei der letztgenannten Variante ist es vorteilhaft, wenn im jeweiligen Iterationsschritt das Modifikationsverfahren erster Art ausgewählt wird, wenn die Empfindlichkeitsangabe betragsmäßig kleiner als 1 ist.

Auch ist es von Vorteil, wenn eines der zumindest zwei Modifikationsverfahren ein Modifikationsverfahren zweiter Art ist, bei dem rückgerechnet wird, wie im letzten Ortsberechnungsverfahren die Kompensationsangabe hätte bemessen sein müssen, um als Fehlerortsangabe denjenigen Schätzort zu erhalten, den die vorherige Kompensationsangabe definiert hat, und die so ermittelte rückgerechnete Kompensationsangabe als neue Kompensationsangabe für den nächsten Iterationschritt festgelegt wird.

Bei der letztgenannten Variante ist es vorteilhaft, wenn im jeweiligen Iterationsschritt das Modifikationsverfahren zweiter Art ausgewählt wird, wenn die Empfindlichkeitsangabe betragsmäßig größer als 1 ist.

Die Iteration wird vorzugsweise wiederholt, bis die Abweichung zwischen der Fehlerortsangabe und der Kompensationsangabe eine vorgegebene Schwelle unterschreitet.

Alternativ oder zusätzlich kann vorgesehen sein, dass die Iteration abgebrochen wird, wenn eine vorgegebene Maximalzahl an Iterationsschritten durchgeführt worden ist.

Die Erfindung bezieht sich darüber hinaus auf ein Schutzgerät zum Orten eines Fehlers in einem Leitungsabschnitt einer dreiphasigen elektrischen Energieübertragungsleitung, wobei das Schutzgerät dazu ausgestaltet ist, zumindest einen Iterationsschritt auszuführen, der umfasst ein Ortsberechnungsverfahren, bei dem eine Fehlerortsangabe unter Berücksichtigung einer Hilfsangabe ermittelt wird, und ein Modifikationsverfahren, bei dem eine modifizierte Hilfsangabe gebildet wird, mit der sich das Ortsberechnungsverfahren wiederholen lässt, um eine neue Fehlerortsangabe zu bilden, wobei das Schutzgerät den Iterationsschritt im Rahmen einer Iteration wiederholt, bis ein vorgegebenes Abbruchkriterium erfüllt wird.

Ein solches Schutzgerät ergibt sich ebenfalls aus der eingangs genannten Veröffentlichungsschrift "Precise Impedance Based Fault Location Algorithm with Fault Resistance Separation".

Erfindungsgemäß ist vorgesehen, dass das Schutzgerät derart ausgestaltet ist, dass die Hilfsangabe eine Kompensationsangabe ist, die einen Schätzort beschreibt, an dem sich der Fehler befinden könnte, und dem Schutzgerät zumindest zwei unterschiedliche Modifikationsverfahren zur Verfügung stehen und das Schutzgerät in jedem Iterationsschritt prüft, welches der Modifikationsverfahren im jeweiligen Iterationsschritt verwendet werden soll, wobei die Wahl des Modifikationsverfahrens von einer Empfindlichkeitsangabe abhängt, die den Einfluss der Kompensationsangabe auf die Fehlerortsangabe quantitativ beschreibt.

Bezüglich der Vorteile des erfindungsgemäßen Schutzgeräts und dessen vorteilhafter Ausgestaltungen sei auf die obigen Ausführungen im Zusammenhang mit dem erfindungsgemäßen Verfahren und dessen vorteilhafter Ausgestaltungen verwiesen.

Das Schutzgerät umfasst vorzugsweise eine Vorstufe und eine der Vorstufe nachgeordnete Iterationsstufe.

Die Vorstufe ist vorzugsweise mit einem Startmodul, einem Ortsberechnungsmodul und einem Differenzbildner ausgestattet.

Die Iterationsstufe umfasst vorzugsweise ein Abbruchsmodul, ein Empfindlichkeitsberechnungsmodul, ein Prüfmodul, eine ein erstes Modifikationsmodul und ein zweites Modifikationsmodul umfassende Modifikationseinrichtung, ein Hochzählmodul, ein Ortsberechnungsmodul und einen Differenzbildner.

Vorteilhaft ist es, wenn das Schutzgerät eine Recheneinrichtung und einen Speicher umfasst. In dem Speicher ist vorzugsweise ein Softwareprogramm bzw. Softwareprogrammprodukt abgespeichert, das bei Ausführung durch die Recheneinrichtung die oben im Zusammenhang mit dem erfindungsgemäßen Verfahren und dessen vorteilhafter Ausgestaltungen beschriebenen Berechnungsschritte ausführt, und/oder eines, mehrere oder alle der oben genannten Module softwaremäßig nachbildet.

Die Erfindung wird nachfolgend anhand von Ausführungsbeispielen näher erläutert; dabei zeigen beispielhaft

Figur 1  einen Leitungsabschnitt einer dreiphasigen Energieübertragungsleitung, die mit einem Ausführungsbeispiel für ein erfindungsgemäßes Schutzgerät ausgestattet ist und anhand derer beispielhaft Ausführungsbeispiele für erfindungsgemäße Verfahren erläutert werden,

Figur 2  Bestandteile eines bevorzugten Ausführungsbeispiels für das Schutzgerät gemäß Figur 1,

Figur 3  beispielhaft anhand dreier Kurven den Einfluss der Empfindlichkeitsangabe auf das Konvergenzverhalten der Iteration, und

Figur 4  eine bevorzugte softwaremäßige Realisierung des in der Figur 2 gezeigten Schutzgeräts.

In den Figuren werden der Übersicht halber für identische oder vergleichbare Komponenten stets dieselben Bezugszeichen verwendet.

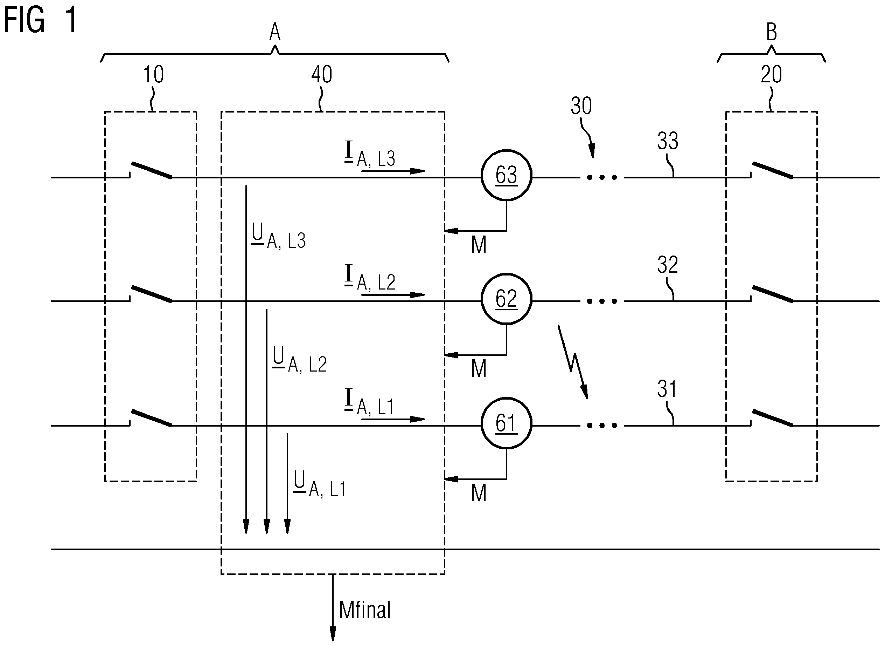

Die Figur 1 zeigt zwei Schalteinrichtungen 10 und 20, die einen Leitungsabschnitt 30 einer dreiphasigen, also drei Phasenleiter 31, 32 und 33 aufweisenden Energieübertragungsleitung begrenzen. Ein nicht gezeigter Sternpunkt der dreiphasigen elektrischen Energieübertragungsleitung kann über eine ebenfalls aus Gründen der Übersicht nicht gezeigte Sternpunktimpedanz, beispielsweise in Form einer Petersenspule, geerdet sein oder isoliert bleiben.

An einem in der Figur 1 linken Abschnittsende A des Leitungsabschnitts 30 ist ein Schutzgerät 40 über Strom- und Spannungswandler 61, 62 und 63 an die Phasenleiter 31, 32 und 33 des Leitungsabschnitts 30 angeschlossen.

Die Strom- und Spannungswandler 61, 62 und 63 übermitteln Messsignale und/oder Messwerte M, die es dem Schutzgerät 40 ermöglichen, in den Phasenleitern 31, 32 und 33 fließende Ströme bzw. daran anliegende Spannungen messtechnisch zu erfassen. Da bei dem Ausführungsbeispiel gemäß Figur 1 die Strom- und Spannungswandler 61, 62 und 63 an dem linken Abschnittsende A des Leitungsabschnitts 30 angeschlossen sind, bildet dieses linke Abschnittsende A die Messstelle des Schutzgeräts 40.

Die Arbeitsweise des Schutzgeräts 40 soll nachfolgend beispielhaft im Zusammenhang mit dem Orten eines zweiphasigen Kurzschlusses zwischen zwei der Phasenleiter, beispielsweise zwischen dem in der Figur 1 untersten Phasenleiter 31 und dem mittleren Phasenleiter 32 erläutert werden. Für die beiden anderen Phasenleiterpaare 31/33 und 32/33 kann die Ortung parallel oder zeitlich versetzt in entsprechender bzw. identischer Weise erfolgen.

Unter Heranziehung der mittels der Strom- und Spannungswandler 61, 62 und 63 erfassten Messsignale bzw. Messwerte M berechnet das Schutzgerät 40 zunächst für jeden der Phasenleiter 31, 32 und 33 jeweils einen Phasenstromzeiger, wie dies im Bereich der Schutztechnik allgemein bekannt und wie es beispielsweise in der eingangs genannten Druckschrift beschrieben ist.

In der Figur 1 ist für den untersten Phasenleiter 31 der Phasenstromzeiger mit dem Bezugszeichen $\underline{I}_{A,L1}$ und der Phase-Erde-Spannungszeiger mit dem Bezugszeichen $\underline{U}_{A,L1}$ gekennzeichnet. Für die beiden anderen Phasenleiter 32 und 33 sind die Phasenstromzeiger mit den Bezugszeichen $\underline{I}_{A,L2}$ bzw. $\underline{I}_{A,L3}$ und die Phase-Erde-Spannungszeiger mit den Bezugszeichen $\underline{U}_{A,L2}$ bzw. $\underline{U}_{A,L3}$ gekennzeichnet.

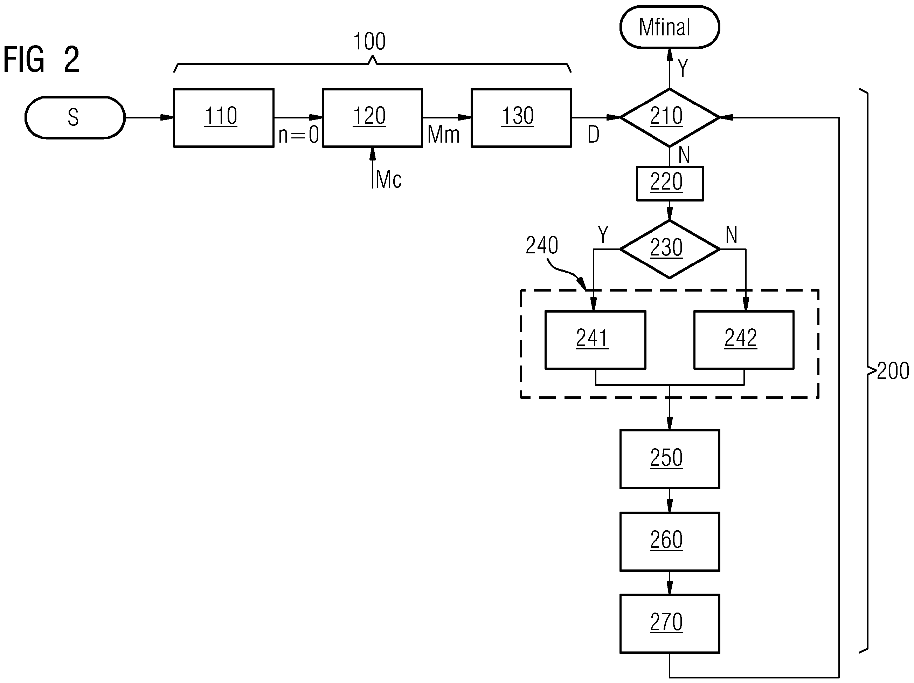

Die Figur 2 zeigt Bestandteile eines Ausführungsbeispiels für das Schutzgerät 40 gemäß Figur 1. Das Ausführungsbeispiel gemäß Figur 2 umfasst eine Vorstufe 100 und eine nachgeordnete Iterationsstufe 200.

Die Vorstufe 100 ist mit einem Startmodul 110, einem Ortsberechnungsmodul 120 und einem Differenzbildner 130 ausgestattet.

Die Iterationsstufe 200 umfasst ein Abbruchsmodul 210, ein Empfindlichkeitsberechnungsmodul 220, ein Prüfmodul 230, eine ein erstes Modifikationsmodul 241 und ein zweites Modifikationsmodul 242 umfassende Modifikationseinrichtung 240, ein Hochzählmodul 250, ein Ortsberechnungsmodul 260 und einen Differenzbildner 270.

Das Schutzgerät 40 gemäß Figur 2 arbeitet vorzugsweise wie folgt:
Nach Eingang eines Startsignals S setzt das Startmodul 110 eine Zählvariable n zunächst auf einen Startwert n=0.

Anschließend errechnet das Ortsberechnungsmodul 120 eine erste Fehlerortsangabe Mm(n=0) unter Heranziehung einer fest vorgegebenen ersten Kompensationsangabe Mc(n=0), die einen dem Schutzgerät 40 als Startwert vorgegebenen Schätzort beschreibt, an dem sich der Fehler befinden könnte. Die Kompensationsangabe könnte man demgemäß auch als Schätzortangabe bezeichnen.

Bei der Fehlerortsangabe Mm und der Kompensationsangabe Mc handelt es sich vorzugsweise um relative Angaben, die den Abstand des Fehlers von der Messstelle - bezogen auf die Länge des Leitungsabschnitts - angeben. Die erste Kompensationsangabe Mc(n=0) kann beispielsweise 0,5 betragen.

Die Berechnung der ersten Fehlerortsangabe Mm(n=0) kann beispielsweise wie folgt erfolgen:

$$Mm(n=0) = \frac{X(n=0)}{Im(\underline{Z}_L)}$$

mit

$$X(n=0) = \frac{\sin\varphi \cdot Im\left\{\left(\underline{U}_{A,Lx} - \underline{U}_{A,Ly}\right) \cdot \underline{I}^*_{A,Cmp} \cdot \underline{\delta}^*_{A,B} \cdot Mc(n=0)\right\}}{Im\left\{e^{j\varphi} \cdot \left(\underline{I}_{A,Lx} - \underline{I}_{A,Ly}\right) \cdot \underline{I}^*_{A,Cmp} \cdot \underline{\delta}^*_{A,B} \cdot Mc(=0)\right\}}$$

wobei $\underline{Z}_L$ die Leitungsimpedanz, $\varphi$ den Leitungswinkel, $\underline{I}_{A,Cmp}$ einen Kompensationsstrom, $\underline{\delta}_{A,B}$ einen Kompensationsfaktor, $\underline{U}_{A,Lx}$ den vom Schutzgerät gemessenen Phasenspannungszeiger der x-ten Phase, $\underline{I}_{A,Lx}$ den vom Schutzgerät gemessenen Phasenstromzeiger in der x-ten Phase, $\underline{U}_{A,Ly}$ den vom Schutzgerät gemessenen Phasenspannungszeiger der y-ten Phase und $\underline{I}_{A,Ly}$ den vom Schutzgerät gemessenen Phasenstromzeiger in der y-ten Phase bezeichnen.

Die Indizes x und y können jeweils 1, 2 oder 3 betragen und die erste, zweite bzw. dritte Phase bezeichnen, wobei für die Berechnung des Fehlerorts bei dem Ausführungsbeispiel gelten soll, dass x ungleich y ist, also zwei unterschiedliche Phasen herangezogen werden.

Die Werte für den Kompensationsstrom $\underline{I}_{A,Cmp}$ und den Kompensationsfaktor $\underline{\delta}_{A,B}$ werden vorzugsweise berechnet, wie dies in der eingangs genannten Literaturstelle beschrieben ist (siehe beispielsweise Formel 16 in Tabelle 1 der Literaturstelle); diesbezüglich sei auf die dortigen Erläuterungen verwiesen.

Der Differenzbildner 130 berechnet anschließend die Differenz D(n=0) zwischen der errechneten Fehlerortsangabe Mm(n=0) und der Kompensationsangabe Mc(n=0) gemäß

$$D(n=0) = Mm(n=0) - Mc(n=0)$$

Die Differenz D(n=0) gelangt zu dem Abbruchsmodul 210 der Iterationsstufe 200. Die Iterationsstufe 200 prüft, ob der Betrag der Differenz D(n=0) eine vorgegebene Differenzschwelle Dmax unterschreitet, also gilt:

$$|D(n=0)| < Dmax$$

Ist die Differenz D(n=0) kleiner als eine Differenzschwelle Dmax (siehe Pfad Y), so wird die errechnete Fehlerortsangabe Mm(n=0) als finale Ortungsangabe Mfinal des Ortungsverfahrens ausgegeben.

Ist die Differenz D(n=0) hingegen nicht kleiner als die Differenzschwelle Dmax, so wird zusätzlich geprüft, wie oft die Berechnung der Fehlerortsangabe Mm bereits erfolgt ist, also welchen Wert die Zählvariable n aufweist. Ist die Zählvariable n größer als ein vorgegebener Maximalwert Nmax, gilt also:

$$n > Nmax,$$

so wird die errechnete Fehlerortsangabe Mm(n=0) als finale Ortungsangabe Mfinal des Ortungsverfahrens ausgegeben (siehe Pfad Y); andernfalls wird die Iterationsstufe 200 durchlaufen (siehe Pfad N).

In der Iterationsstufe 200 wird zunächst das Empfindlichkeitsberechnungsmodul 220 die Berechnung einer Empfindlichkeitsangabe E durchführen, vorzugsweise durch Ableitung der Fehlerortsangabe Mm nach der Kompensationsangabe Mc gemäß

$$E = dMm/dMc$$

wobei E die Empfindlichkeitsangabe, Mm die Fehlerortsangabe und Mc die Kompensationsangabe bezeichnet.

Die Empfindlichkeitsangabe E wird vorzugsweise durch numerische Differentiation ermittelt. Beispielsweise kann die Berechnung der Fehlerortsangabe unter Heranziehung zweier weiterer Kompensationsangaben Mc' und Mc" erfolgen, von denen eine geringfügig größer als die aktuelle Kompensationsangabe Mc(n) und die andere geringfügig kleiner ist, also gilt:

$$Mc'(n) = (1+q) \cdot Mc(n)$$

und

$$Mc''(n) = (1-q) \cdot Mc(n)$$

wobei q eine Konstante ist, die größer als Null, aber sehr viel kleiner als 1 ist und beispielsweise 0,01 beträgt.

Das Empfindlichkeitsberechnungsmodul 220 erhält dann zwei Fehlerortsangaben Mm(Mc'(n)) und Mm(Mc"(n)) und kann die Empfindlichkeitsangabe E berechnen bzw. abschätzen gemäß:

$$E = |Mm(Mc'(n)) - Mm(Mc''(n))| / 2q$$

Die Empfindlichkeitsangabe E gelangt zu dem Prüfmodul 230, das prüft, ob die Empfindlichkeitsangabe E betragsmäßig eine vorgegebene Empfindlichkeitsschwelle Emax unterschreitet oder nicht. Die Empfindlichkeitsschwelle Emax beträgt vorzugsweise 1 oder zumindest näherungsweise 1 (z. B. 1 $\pm$ 10%).

Unterschreitet die Empfindlichkeitsangabe E betragsmäßig die vorgegebene Empfindlichkeitsschwelle Emax (siehe Pfad Y), gilt also

$$E < Emax,$$

so führt das erste Modifikationsmodul 241 ein Modifikationsverfahren erster Art durch, indem es die bisherige Kompensationsangabe unter Bildung einer modifizierten Kompensationsangabe modifiziert, und zwar in Abhängigkeit von der zuletzt ermittelten Fehlerortsangabe Mm(n).

Vorzugsweise legt das erste Modifikationsmodul 241 die im vorherigen Ortsberechnungsverfahren ermittelte letzte Fehlerortsangabe Mm(n) unmittelbar bzw. unverändert als modifizierte Kompensationsangabe für den nächsten Iterationsschritt fest; es gilt dann also

$$Mc(n+1) = Mm(n)$$

Unterschreitet die Empfindlichkeitsangabe E betragsmäßig die vorgegebene Empfindlichkeitsschwelle Emax hingegen nicht (siehe Pfad N), so führt das zweite Modifikationsmodul 242 ein anderes Modifikationsverfahren, also ein Modifikationsverfahren zweiter Art, durch, wobei es rückrechnet, wie im letzten Ortsberechnungsverfahren die Kompensationsangabe Mc(n) hätte bemessen sein müssen, um als Fehlerortsangabe Mm(n) denjenigen Schätzort zu erhalten, den die vorherige Kompensationsangabe Mc(n) definiert hat. Die neue bzw. modifizierte Kompensationsangabe Mc(n+1) errechnet das zweite Modifikationsmodul 242 vorzugsweise durch numerisches Lösen der folgenden Formel:

$$\text{Mc}(n+1) = X^{-1}(mc(n) \cdot \text{Im}(\underline{Z}_L))$$

mit

$$X(n) = \frac{\sin\varphi \cdot Im\left\{\left(\underline{U}_{A,Lx} - \underline{U}_{A,Ly}\right) \cdot \underline{I}^{*}_{A,Cmp} \cdot \underline{\delta}^{*}_{A,B} \cdot Mc(n)\right\}}{Im\left\{e^{j\varphi} \cdot \left(\underline{I}_{A,Lx} - \underline{I}_{A,Ly}\right) \cdot \underline{I}^{*}_{A,Cmp} \cdot \underline{\delta}^{*}_{A,B} \cdot Mc(n)\right\}}$$

Nachdem das erste Modifikationsmodul 241 oder das zweite Modifikationsmodul 242 die neue bzw. modifizierte Kompensationsangabe Mc(n+1) errechnet hat, kann das Hochzählmodul 250 die Zählvariable um Eins hochsetzen.

Das Ortsberechnungsmodul 260 berechnet anschließend - analog zum Ortsberechnungsmodul 120 - die Fehlerortsangabe Mm(n) für die neue hochgesetzte Zählvariable n gemäß:

$$Mm(n) = \frac{X(n)}{Im(\underline{Z}_L)}$$

mit

$$X(n) = \frac{\sin\varphi \cdot Im\left\{\left(\underline{U}_{A,Lx} - \underline{U}_{A,Ly}\right) \cdot \underline{I}^{*}_{A,Cmp} \cdot \underline{\delta}^{*}_{A,B} \cdot Mc(n)\right\}}{Im\left\{e^{j\varphi} \cdot \left(\underline{I}_{A,Lx} - \underline{I}_{A,Ly}\right) \cdot \underline{I}^{*}_{A,Cmp} \cdot \underline{\delta}^{*}_{A,B} \cdot Mc(n)\right\}}$$

Der nachgeordnete Differenzbildner 270 berechnet anschließend - analog zum Differenzbildner 130 - die Differenz D(n) zwischen der errechneten Fehlerortsangabe Mm(n) und der Kompensationsangabe Mc(n) gemäß

$$D(n) = Mm(n) - Mc(n)$$

Die Differenz D(n) gelangt zurück zu dem Abbruchsmodul 210 der Iterationsstufe 200, sodass die Iterationsstufe 200 nun komplett durchlaufen worden ist.

Das Iterationsverfahren wird mit dem nächsten Iterationsschritt wiederholt und es wird also die Iterationsstufe 200 erneut durchlaufen, wenn das Abbruchsmodul 210 dies verlangt (siehe Pfad N), wenn also konkret der Betrag der Differenz D(n) die vorgegebene Differenzschwelle Dmax noch nicht unterschreitet oder die Zählvariable n den vorgegebenen Maximalwert Nmax noch nicht überschreitet; andernfalls (siehe Pfad Y) wird die aktuelle Fehlerortsangabe Mm(n) des letzten Durchlaufs der Iterationsstufe 200 als finale Fehlerortsangabe Mfinal ausgegeben.

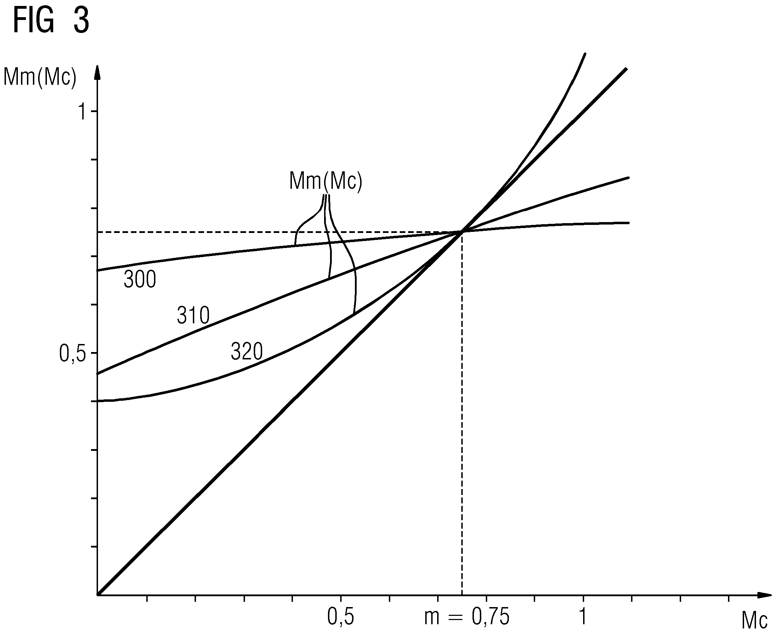

Die Figur 3 zeigt anhand dreier Kurven 300, 310 und 320 den Einfluss der Empfindlichkeitsangabe E auf das Konvergenzverhalten der Iteration; dabei zeigt die Kurve 300 einen typischen Verlauf der Fehlerortsangabe Mm in Abhängigkeit von der Kompensationsangabe Mc für eine betragsmäßig sehr kleine Empfindlichkeitsangabe E (|E| << 1), die Kurve 310 einen typischen Verlauf für eine betragsmäßig kleine Empfindlichkeitsangabe E (|E| < 1) und die Kurve 320 einen typischen Verlauf für eine betragsmäßig große Empfindlichkeitsangabe E (|E| > 1).

Bei betragsmäßig kleiner Empfindlichkeitsangabe E mit |E| < 1 konvergiert die Iteration auf der Basis des Modifikationsverfahrens erster Art, und zwar umso schneller, je kleiner der Betrag der Empfindlichkeitsangabe E ist.

Bei betragsmäßig großer Empfindlichkeitsangabe (|E| > 1) konvergiert die Iteration auf der Basis des Modifikationsverfahrens erster Art nicht mehr, sie konvergiert jedoch auf der Basis des Modifikationsverfahrens zweiter Art, und zwar umso schneller, je größer der Betrag der Empfindlichkeitsangabe E ist.

Zusammengefasst kann durch die Auswahl eines von der Empfindlichkeitsangabe E abhängigen, geeigneten Modifikationsverfahrens stets ein Konvergieren der Iteration gewährleistet werden.

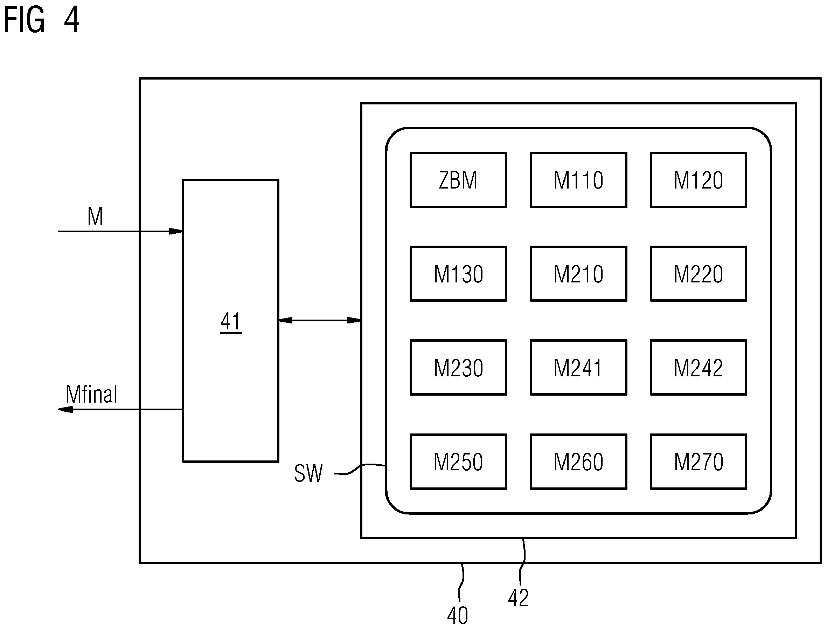

Die in der Figur 2 gezeigten Komponenten, also das Startmodul 110, das Ortsberechnungsmodul 120, der Differenzbildner 130, das Abbruchsmodul 210, das Empfindlichkeitsberechnungsmodul 220, das Prüfmodul 230, das erste Modifikationsmodul 241, das zweite Modifikationsmodul 242, das Hochzählmodul 250, das Ortsberechnungsmodul 260 und der Differenzbildner 270 können separate Komponenten sein, die beispielsweise durch separate elektronische Bauelemente gebildet sein können; alternativ können die genannten Komponenten auch durch Softwaremodule gebildet werden, wie nachfolgend im Zusammenhang mit der Figur 4 beispielhaft näher erläutert wird.

Die Figur 4 zeigt eine bevorzugte softwaremäßige Implementierung des in der Figur 2 gezeigten Schutzgeräts 40. Das Schutzgerät 40 umfasst eine Recheneinrichtung 41 und einen Speicher 42. In dem Speicher 42 ist ein Softwareprogrammprodukt SW abgespeichert, das bei Ausführung durch die Recheneinrichtung 41 die oben im Zusammenhang mit den Figuren 1 und 2 beschriebenen Berechnungsschritte ausführt.

Zu diesem Zwecke umfasst das Softwareprogrammprodukt SW gemäß Figur 4 vorzugsweise ein Zeigerbildungsmodul ZBM zur Bildung der Phasenstromzeiger $\underline{I}_{A,L1}$, $\underline{I}_{A,L2}$ und $\underline{I}_{A,L3}$ und der Phase-Erde-Spannungszeiger $\underline{U}_{A,L1}$, $\underline{U}_{A,L2}$ und $\underline{U}_{A,L3}$ anhand von Abtastwerten, die auf der Basis der Messsignale bzw. Messwerte M der Strom- und Spannungswandler 61, 62 und 63 erzeugt werden oder in diesen bereits enthalten sind.

Außerdem umfasst das Softwareprogrammprodukt für jedes der in der Figur 2 gezeigten Komponenten, also das Startmodul 110, das Ortsberechnungsmodul 120, den Differenzbildner 130, das Abbruchsmodul 210, das Empfindlichkeitsberechnungsmodul 220, das Prüfmodul 230, das erste Modifikationsmodul 241, das zweite Modifikationsmodul 242, das Hochzählmodul 250, das Ortsberechnungsmodul 260 und den Differenzbildner 270, jeweils ein korrespondierendes Softwaremodul M110, M120, M130, M210, M220, M230, M241, M242, M250, M260 und M270, die bei Ausführung durch die Recheneinrichtung 41 jeweils die Funktion der jeweils zugeordneten Komponente realisieren.

Die Erfindung wird durch die beigefügten Ansprüche definiert.

**Patentansprüche**

1. Verfahren zum Orten eines Fehlers in einem Leitungsabschnitt (30) einer dreiphasigen elektrischen Energieübertragungsleitung, wobei bei dem Verfahren zumindest ein Iterationsschritt ausgeführt wird, der umfasst

   - ein Ortsberechnungsverfahren, bei dem eine Fehlerortsangabe (Mm) unter Berücksichtigung einer Hilfsangabe ermittelt wird, und
   - ein Modifikationsverfahren, bei dem eine modifizierte Hilfsangabe gebildet wird, mit dem sich das Ortsberechnungsverfahren wiederholen lässt, um eine neue Fehlerortsangabe (Mm) zu bilden,
   - wobei der Iterationsschritt im Rahmen einer Iteration wiederholt wird, bis ein vorgegebenes Abbruchkriterium **er**füllt wird,
   **dadurch gekennzeichnet, dass**
   - die Hilfsangabe eine Kompensationsangabe (Mc) ist, die einen Schätzort beschreibt, an dem sich der Fehler befinden könnte, und
   - zumindest zwei unterschiedliche Modifikationsverfahren zur Verfügung stehen und in jedem Iterationsschritt geprüft wird, welches der Modifikationsverfahren im jeweiligen Iterationsschritt verwendet werden soll,
   - wobei die Wahl des Modifikationsverfahrens von einer Empfindlichkeitsangabe (E) abhängt, die den Einfluss der Kompensationsangabe (Mc) auf die Fehlerortsangabe (Mm) quantitativ beschreibt.

2. Verfahren nach Anspruch 1,
   **dadurch gekennzeichnet, dass**
   die Empfindlichkeitsangabe (E) berechnet wird durch Ableitung der Fehlerortsangabe (Mm) nach der Kompensationsangabe (Mc) gemäß

$$E = dMm/dMc$$

   wobei E die Empfindlichkeitsangabe, Mm die Fehlerortsangabe und Mc die Kompensationsangabe bezeichnet.

3. Verfahren nach einem der voranstehenden Ansprüche,
   **dadurch gekennzeichnet, dass**
   die Empfindlichkeitsangabe (E) durch numerische Differentiation ermittelt wird.

4. Verfahren nach einem der voranstehenden Ansprüche,
   **dadurch gekennzeichnet, dass**
   bei jedem der zwei Modifikationsverfahren die modifizierte Kompensationsangabe (Mc) jeweils in Abhängigkeit von der zuletzt ermittelten Fehlerortsangabe (Mm) ermittelt wird.

5. Verfahren nach einem der voranstehenden Ansprüche,
   **dadurch gekennzeichnet, dass**
   eines der zumindest zwei Modifikationsverfahren ein Modifikationsverfahren erster Art ist, bei dem die im vorherigen Ortsberechnungsverfahren ermittelte letzte Fehlerortsangabe (Mm) als modifizierte Kompensationsangabe (Mc) für den nächsten Iterationsschritt festgelegt wird.

6. Verfahren nach Anspruch 5,
**dadurch gekennzeichnet, dass**
im jeweiligen Iterationsschritt das Modifikationsverfahren erster Art ausgewählt wird, wenn die Empfindlichkeitsangabe (E) betragsmäßig kleiner als 1 ist.

7. Verfahren nach einem der voranstehenden Ansprüche,
**dadurch gekennzeichnet, dass**
eines der zumindest zwei Modifikationsverfahren ein Modifikationsverfahren zweiter Art ist, bei dem

- rückgerechnet wird, wie im letzten Ortsberechnungsverfahren die Kompensationsangabe (Mc) hätte bemessen sein müssen, um als Fehlerortsangabe (Mm) denjenigen Schätzort zu erhalten, den die vorherige Kompensationsangabe (Mc) definiert hat, und
- die so ermittelte rückgerechnete Kompensationsangabe (Mc) als neue Kompensationsangabe (Mc) für den nächsten Iterationschritt festgelegt wird.

8. Verfahren nach Anspruch 7,
**dadurch gekennzeichnet, dass**
im jeweiligen Iterationsschritt das Modifikationsverfahren zweiter Art ausgewählt wird, wenn die Empfindlichkeitsangabe (E) betragsmäßig größer als 1 ist.

9. Verfahren nach einem der voranstehenden Ansprüche,
**dadurch gekennzeichnet, dass**
die Iteration wiederholt wird, bis die Abweichung zwischen der Empfindlichkeitsangabe (E) und der Kompensationsangabe (Mc) eine vorgegebene Schwelle unterschreitet.

10. Verfahren nach einem der voranstehenden Ansprüche,
**dadurch gekennzeichnet, dass**
die Iteration abgebrochen wird, wenn eine vorgegebene Maximalzahl an Iterationsschritten durchgeführt worden ist.

11. Verfahren nach einem der voranstehenden Ansprüche,
**dadurch gekennzeichnet, dass**
die Fehlerortsangabe (Mm) und die Kompensationsangabe (Mc) relative Angaben sind und definieren, welchen Abstand der Fehler von der Messstelle bezogen auf die Länge des Leitungsabschnitts (30) aufweist.

12. Schutzgerät (40) zum Orten eines Fehlers in einem Leitungsabschnitt (30) einer dreiphasigen elektrischen Energieübertragungsleitung, wobei das Schutzgerät (40) dazu ausgestaltet ist, zumindest einen Iterationsschritt auszuführen, der umfasst

- ein Ortsberechnungsverfahren, bei dem eine Fehlerortsangabe (Mm) unter Berücksichtigung einer Hilfsangabe ermittelt wird, und
- ein Modifikationsverfahren, bei dem eine modifizierte Hilfsangabe gebildet wird, mit der sich das Ortsberechnungsverfahren wiederholen lässt, um eine neue Fehlerortsangabe (Mm) zu bilden,
- wobei das Schutzgerät (40) den Iterationsschritt im Rahmen einer Iteration wiederholt, bis ein vorgegebenes Abbruchkriterium erfüllt wird,
**dadurch gekennzeichnet, dass**
- die Hilfsangabe eine Kompensationsangabe (Mc) ist, die einen Schätzort beschreibt, an dem sich der Fehler befinden könnte, und
- dem Schutzgerät (40) zumindest zwei unterschiedliche Modifikationsverfahren zur Verfügung stehen und das Schutzgerät (40) in jedem Iterationsschritt prüft, welches der Modifikationsverfahren im jeweiligen Iterationsschritt verwendet werden soll,
- wobei die Wahl des Modifikationsverfahrens von einer Empfindlichkeitsangabe (E) abhängt, die den Einfluss der Kompensationsangabe (Mc) auf die Fehlerortsangabe (Mm) quantitativ beschreibt.

**Claims**

1. Method for locating a fault in a line section (30) of a three-phase electrical power transmission line, wherein, in the method, at least one iteration step is carried out, which comprises

   - a location calculation method in which a fault location indication (Mm) is determined taking into account an auxiliary indication, and
   - a modification method in which a modified auxiliary indication is formed, which enables the location calculation method to be repeated in order to form a new fault location indication (Mm),
   - wherein the iteration step is repeated as part of an iteration until a predetermined termination criterion is met, **characterized in that**
   - the auxiliary indication is a compensation indication (Mc) describing an estimated location where the fault could be located, and
   - at least two different modification methods are available and, in each iteration step, a check determines which of the modification methods is to be used in the respective iteration step,
   - wherein the selection of the modification method depends on a sensitivity indication (E) which quantitatively describes the influence of the compensation indication (Mc) on the fault location indication (Mm).

2. Method according to Claim 1,
   **characterized in that**
   the sensitivity indication (E) is calculated by deriving the fault location indication (Mm) according to the compensation indication (Mc) according to

   $$E = dMm/dMc$$

   wherein E denotes the sensitivity indication, Mm denotes the fault location indication and Mc denotes the compensation indication.

3. Method according to either one of the preceding claims,
   **characterized in that**
   the sensitivity indication (E) is determined by numerical differentiation.

4. Method according to any one of the preceding claims,
   **characterized in that**
   the modified compensation indication (Mc) is determined in each of the two modification methods depending on the last determined fault location indication (Mm).

5. Method according to any one of the preceding claims,
   **characterized in that**
   one of the at least two modification methods is a modification method of the first type, in which the last fault location indication (Mm) determined in the previous location calculation method is defined as the modified compensation indication (Mc) for the next iteration step.

6. Method according to Claim 5,
   **characterized in that**
   the modification method of the first type is selected in the respective iteration step if the sensitivity indication (E) is less than 1.

7. Method according to any one of the preceding claims,
   **characterized in that**
   one of the at least two modification methods is a modification method of the second type, in which

   - how the compensation indication (Mc) should have been dimensioned in the last location calculation method is recalculated in order to obtain the fault location indication (Mm) that was defined by the previous compensation indication (Mc), and
   - the compensation indication (Mc) recalculated in this way is defined as the new compensation indication (Mc) for the next iteration step.

8. Method according to Claim 7,
**characterized in that**
the modification method of the second type is selected in the respective iteration step if the sensitivity indication (E) is greater than 1.

9. Method according to any one of the preceding claims,
**characterized in that**
the iteration is repeated until the deviation between the sensitivity indication (E) and the compensation indication (Mc) falls below a specified threshold.

10. Method according to any one of the preceding claims,
**characterized in that**
the iteration is terminated if a specified maximum number of iteration steps has been performed.

11. Method according to any one of the preceding claims,
**characterized in that**
the fault location indication (Mm) and the compensation indication (Mc) are relative indications and define the distance between the fault and the measuring point in relation to the length of the line section (30).

12. Protective device (40) for locating a fault in a line section (30) of a three-phase electrical power transmission line, wherein the protective device (40) is designed to carry out at least one iteration step comprising

- a location calculation method in which a fault location indication (Mm) is determined taking into account an auxiliary indication, and
- a modification method in which a modified auxiliary indication is formed, which enables the location calculation method to be repeated in order to form a new fault location indication (Mm),
- wherein the protective device (40) repeats the iteration step as part of an iteration until a predetermined termination criterion is met,
**characterized in that**
- the auxiliary indication is a compensation indication (Mc) describing an estimated location where the fault could be located, and
- at least two different modification methods are available to the protective device (40) and the protective device (40) checks in each iteration step which of the modification methods is to be used in the respective iteration step,
- wherein the selection of the modification method depends on a sensitivity indication (E) which quantitatively describes the influence of the compensation indication (Mc) on the fault location indication (Mm).

**Revendications**

1. Procédé de localisation d'un défaut dans un tronçon (30) d'une ligne de transport d'énergie électrique triphasée, dans lequel dans le procédé on effectue au moins un stade d'itération, qui comprend

- un procédé de calcul d'emplacement, dans lequel on détermine une indication (Mm) d'emplacement du défaut en tenant compte d'une indication auxiliaire, et
- un procédé de modification, dans lequel on forme une indication auxiliaire modifiée, avec laquelle on peut répéter le procédé de calcul d'emplacement, afin de former une nouvelle indication (Mm) d'emplacement du défaut,
- dans lequel on répète le stade d'itération dans le cadre d'une itération, jusqu'à satisfaire un critère d'interruption donné à l'avance,
**caractérisé en ce que**
- l'indication auxiliaire est une indication (Mc) de compensation, qui décrit un emplacement estimé où le défaut pourrait se trouver, et
- on dispose d'au moins deux procédés de modification différents et on vérifie, dans chaque stade d'itération, celui des procédés de modification qu'il faut utiliser dans chaque stade d'itération,
- dans lequel le choix du procédé de modification dépend d'une indication (E) de sensibilité, qui décrit quantitativement l'influence de l'indication (Mc) de compensation sur l'indication (Mm) d'emplacement du défaut.

2. Procédé suivant la revendication 1,

**caractérisé en ce que** l'
on calcule l'indication (E) de sensibilité en déduisant l'indication (Mm) d'emplacement du défaut de l'indication (Mc) de compensation suivant

$$E = dMm/dMc$$

dans lequel E est l'indication de sensibilité, Mm l'indication d'emplacement du défaut et Mc l'indication de compensation.

3. Procédé suivant l'une des revendications précédentes,
   **caractérisé en ce que** l'
   on détermine l'indication (E) de sensibilité par différenciation numérique.

4. Procédé suivant l'une des revendications précédentes,
   **caractérisé en ce que**
   pour chacun des deux procédés de modification, on détermine l'indication (Mc) de compensation modifiée respectivement en fonction de l'indication (Mm) d'emplacement du défaut déterminée en dernier.

5. Procédé suivant l'une des revendications précédentes,
   **caractérisé en ce que**
   l'un des au moins deux procédés de modification est un procédé de modification d'un premier type, dans lequel on fixe, pour le stade d'itération venant immédiatement ensuite, comme indication (Mc) de compensation modifiée la dernière indication (Mm) d'emplacement du défaut déterminée dans le procédé précédent de calcul de l'emplacement.

6. Procédé suivant la revendication 5,
   **caractérisé en ce que**
   dans chaque stade d'itération on choisit le procédé de modification du premier type, si l'indication (E) de sensibilité est plus petite que 1 en valeur absolue.

7. Procédé suivant l'une des revendications précédentes,
   **caractérisé en ce que**
   l'un des au moins deux procédés de modification est un procédé de modification d'un deuxième type, dans lequel

   - on recalcule ce qu'aurait dû être, dans le dernier procédé de calcul d'emplacement, l'indication (Mc) de compensation pour obtenir, comme indication (Mm) d'emplacement du défaut, le même emplacement estimé que l'indication (Mc) de compensation précédente a défini, et
   - on fixe pour le stade d'itération venant immédiatement ensuite l'indication (Mc) de compensation recalculée ainsi déterminée comme nouvelle indication (Mc) de compensation.

8. Procédé suivant la revendication 7,
   **caractérisé en ce que**
   dans le stade d'itération respectif, on choisit le procédé de modification du deuxième type, si l'indication (E) de sensibilité est en valeur absolue plus grande que 1.

9. Procédé suivant l'une des revendications précédentes,
   **caractérisé en ce que** l'
   on répète l'itération jusqu'à ce que l'écart entre l'indication (E) de sensibilité et l'indication (Mc) de compensation soit inférieur à un seuil donné à l'avance.

10. Procédé suivant l'une des revendications précédentes,
    **caractérisé en ce que** l'
    on interrompt l'itération, si un nombre maximum donné à l'avance de stades d'itération a été effectué.

11. Procédé suivant l'une des revendications précédentes,
    **caractérisé en ce que**
    l'indication (Mm) d'emplacement du défaut et l'indication (Mc) de compensation sont des indications relatives et définissent la distance du défaut au point de mesure rapporté à la longueur du tronçon (30) de la ligne.

12. Appareil (40) de protection pour la localisation d'un défaut dans un tronçon (30) d'une ligne de transport d'énergie électrique triphasée, dans lequel l'appareil (40) de protection est conformé pour effectuer au moins un stade d'itération, qui comprend

- un procédé de calcul d'emplacement, dans lequel on détermine une indication (Mm) d'emplacement du défaut en tenant compte d'une indication auxiliaire, et
- un procédé de modification, dans lequel on forme une indication auxiliaire modifiée, avec laquelle on peut répéter le procédé de calcul d'emplacement, afin de former une nouvelle indication (Mm) d'emplacement du défaut,
- dans lequel l'appareil (40) de protection répète le stade d'itération dans le cadre d'une itération jusqu'à ce qu'un critère d'interruption donné à l'avance soit satisfait, **caractérisé en ce que**
- l'indication auxiliaire est une indication (Mc) de compensation, qui décrit un emplacement estimé où le défaut pourrait se trouver, et
- l'appareil (40) de protection dispose d'au moins deux procédés de modification différents et l'appareil (40) de protection vérifié, dans chaque stade d'itération, celui des procédés de modification qu'il faut utiliser dans chaque stade d'itération,
- dans lequel le choix du procédé de modification dépend d'une indication (E) de sensibilité, qui décrit quantitativement l'influence de l'indication (Mc) de compensation sur l'indication (Mm) d'emplacement du défaut.

FIG 1

FIG 2

FIG 3

EP 4 310 521 B1

FIG 4

M →

Mfinal ←

41

SW

ZBM   M110   M120

M130   M210   M220

M230   M241   M242

M250   M260   M270

40   42

EP 4 310 521 B1